# EUROPEAN PATENT APPLICATION

(11) **EP 4 838 243 A1**
(43) Date of publication of application: **11.11.2026**
(21) Application number: 25174715.0
(22) Date of filing: 07.05.2025
(51) Int. Cl.: G01R 33/00, G01R 33/09

(54) **INTEGRATED CIRCUIT, FABRICATION METHOD FOR A MONOLITHIC DIE, MAGNETIC SENSOR, AND AN ENCODER**

(71) Applicant: TE Connectivity Solutions GmbH, 8200 Schaffhausen (CH); TE Connectivity Smart Grid GmbH, 44227 Dortmund (DE)
(72) Inventor: POENARU, Ilie, 8200 Schaffhausen (CH); SCHAPENDONK, Edwin, 8200 Schaffhausen (CH); BARTOS, Axel, 44227 Dortmund (DE)
(74) Representative: Grünecker Patent- und Rechtsanwälte PartG mbB

(57) **Abstract**

The present disclosure relates to an integrated circuit, IC, (1) having a layered structure. The IC comprising a processing layer (10) comprising a circuitry (100) for communicating with a magnetoresistance, MR , sensor (200); a sensing layer (20) comprising the MR sensor (200) for detecting an external magnetic field (H0); and an attenuating layer (30) comprising a magnetic flux concentrator, MFC, (300) for attenuating the external magnetic field (H0) through the MR sensor (200); wherein a monolithic die comprises the processing layer (10), the sensing layer (20), and the attenuation layer (30).

## Description

The invention relates to an integrated circuit (IC), a method of manufacturing a monolithic chip, a magnetic sensor comprising the IC, and an encoder comprising the magnetic sensor.

Magnetic sensors are widely used in various industries for detecting and measuring magnetic fields, position, speed, and current. For example, in automotive applications, they are used for ABS (anti-lock braking systems), speedometers, and electronic compasses. In consumer electronics, they can enable features such as magnetic switches in smartphones, compass modules such as in GPS devices, and contactless sensing in wireless charging. Industrial applications include motor control, current sensing in power systems, and position sensing in robotics. In addition, magnetic sensors play a critical role in medical imaging (MRI), biomagnetic diagnostics, and security systems for metal detection and surveillance.

Despite their advantages, magnetic sensors face several challenges, including sensitivity to external electromagnetic interference (EMI), which can cause inaccurate readings. Temperature variations can also affect sensor accuracy and stability. In applications requiring high accuracy, magnetic noise and drift are significant problems. Another limitation is the dependence on the strength and consistency of the external magnetic field. The sensor can degrade in response to strong external fields and/or harsh environments. In addition, miniaturization of magnetic sensors while maintaining performance remains a technical challenge in advanced electronic devices. In other words, sensor accuracy, resolution, linearity, and long-term drift over lifetime are particularly challenging for magnetic sensors.

There are several types of magnetic sensors, which can be classified according to their operating principles. Hall effect sensors, for example, detect magnetic fields via voltage differences. The sensitivity of Hall sensors is typically in the range of 1-100 mV/mT. Alternatively, magnetoresistance (MR) sensors, including anisotropic magnetoresistance (AMR) sensors, giant magnetoresistance (GMR) sensors, and tunnel magnetoresistance (TMR) sensors, change resistance in response to magnetic fields. The sensitivity of TMR sensors, for example in Wheatstone bridge configuration, is typically in the range of 100-1000 mV/mT. Other sensor principles include fluxgate, inductive and eddy current sensors. Each type has specific advantages that make it suitable for different environments and/or accuracy requirements.

MR technology in particular, like TMR technology, offers the advantage of high sensitivity. However, MR technology, especially TMR technology, can be susceptible to parameter drift. In particular, TMR sensor technology can exhibit parameter drift when exposed to strong magnetic fields.

The object of the invention is to provide a magnetic sensor having high sensitivity. Another object is to provide a sensor having long-term sensor stability, i.e. a sensor that is insensitive to effects that degrade sensor performance, such as those caused by saturation and drift. Another object is to miniaturize the sensor. Yet another object is low-cost production.

At least one of the above objects is solved by the independent claims. Advantageous embodiments are solved by the dependent claims.

According to a general aspect, a monolithic die comprises a circuitry and a magnetoresistance (MR) sensor. The monolithic die further comprises an attenuating layer comprising a magnetic flux concentrator (MFC) for attenuating the external magnetic field through the MR sensor.

As used herein, a **monolithic die** refers to an integrated circuit (IC) in which all circuit components - such as transistors, resistors, capacitors, and interconnects - are fabricated on a single semiconductor substrate (die), typically silicon. In other words, the entire circuit functions as a single piece of substrate, such as silicon, without the need for external connections between separate functional units. A monolithic die enables at least one of high integration density, lower power consumption, and improved electrical performance, for example due to reduced parasitics. It typically enables higher reliability, compactness, and cost-effectiveness at high volumes, but it faces yield challenges, e.g., a defect in any part of the die can render the entire chip unusable. Unlike a monolithic die, a multi-chip module (MCM) integrates multiple semiconductor dies in a single package.

In particular, with respect to the general aspect, the monolithic die, also referred to as a single chip, allows embedding a processing layer, e.g. a CMOS layer, a sensing layer, e.g. a layer comprising an MR sensor such as a TMR sensor formed by TMR stack layers, and an attenuating layer comprising an MFC in a single piece. This makes it possible to combine high sensitivity, long-term stability and economical fabrication. In particular, deposition of the attenuating layer on a silicon wafer after completion of processing layers, such as CMOS layers and/or sensing layers, is a particularly economical process. Furthermore, the attenuating layer makes it possible to protect the MR sensor from strong magnetic fields, which facilitates to protect the MR sensor from strong external magnetic fields that may cause drift or saturation of the MR sensor. It should be understood that the processing layer, e.g. the CMOS layer, can be fabricated in first fabrication process, e.g. in a CMOS clean room. The sensing layer can realized for example in a back end of line process, for example outside the CMOS clean room. The attenuating layer is realized for example in the back end of line process. Monolithically integrated means built on top of each other here.

The invention will now be described in more detail and by way of example using advantageous embodiments and with reference to the drawings. The embodiments described are only possible configurations in which the individual features described may be provided independently of one another or may be omitted.

The accompanying drawings are incorporated in and made a part of the specification to illustrate various embodiments of the present invention. These drawings, together with the specification, serve to explain the principles of the invention. The drawings are intended only to illustrate the preferred and alternative examples of how the invention may be made and used, and are not to be construed as limiting the invention to only the embodiments illustrated and described. In addition, several aspects of the embodiments, individually or in different combinations, may constitute solutions according to the present invention. Thus, the following described embodiments may be considered either alone or in any combination thereof. The described embodiments are only possible configurations and it must be kept in mind that the individual features as described above can be provided independently of each other or can be omitted altogether when implementing this invention. Further features and advantages will become apparent from the following more detailed description of the various embodiments of the invention as illustrated in the accompanying drawings, wherein like references refer to like elements and wherein:
- **FIG. 1**: is a cross-sectional perspective view of an integrated circuit according to an example;
- **FIGS. 2 to 6**: are modifications of the example of Fig. 1;
- **FIG. 7**: is a cross-sectional perspective view of a rotary encoder;
- **FIG. 8**: is a cross-sectional perspective view of a rotary encoder according to an example;
- **FIGS. 9 and 10**: are schematic diagrams explaining the operating principle of a rotary encoder according to Figs. 7 and 8; and
- **FIGS. 11 and 12**: are vector diagrams showing an influence of a disturbing magnetic field.

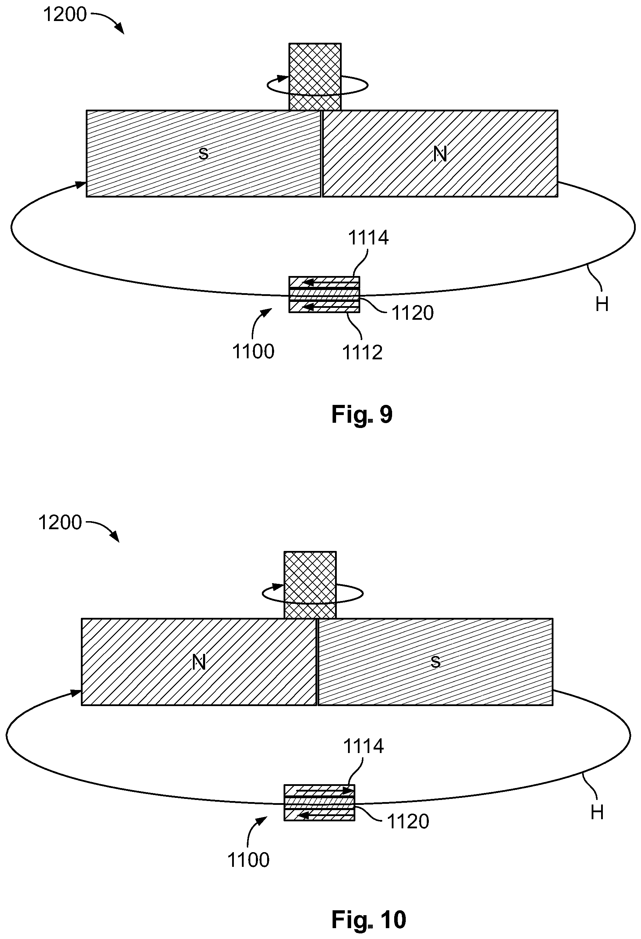

This application specifically discusses sensors and encoders, such as an encoder 1000 shown in Figs. 9 and 10. An encoder is a devices that converts a position into an electronic signal. For example, the rotational position of a magnet 1200 is converted into an electronic signal by the sensor 1100. Although not shown in the figures, the present disclosure is not limited to a position sensor, but may also be applicable to other types of sensors, such as current sensors or magnetic sensors.

For example, in the example shown in Figures 9 and 10, the encoder 1100 is a TMR sensor. Tunnel magnetoresistance (TMR) is a magnetoresistive effect that occurs in a magnetic tunnel junction (MTJ), which is a device comprising two ferromagnetic layers 1112, 1114 separated by a thin insulator 1120. Figures 9 and 10 simplify the ferromagnetic layers 1112, 1114 as a single layer. Each of the two ferromagnetic layers may comprise a plurality of layers. Because the insulating layer 1120 is thin (typically a few nanometers), electrons can tunnel from one ferromagnetic layer 1114 to the other layer 1112. Since this process is forbidden in classical physics, tunneling magnetoresistance is a strictly quantum mechanical phenomenon and lies in the study of spintronics.

The direction of magnetization of at least one of the ferromagnetic layers can be individually switched resp rotated by an external magnetic field H. For example, the permanent magnet 1200 generates a first magnetic field as shown in FIG. 9 and an opposing second magnetic field depending on the position as shown in FIG. 10. With respect to the first magnetic field, the magnetization in layers 1114 and 1116 is parallel. For example, if the magnetizations are in a parallel orientation, it is more likely that electrons will tunnel through the insulating layer 1120 than if they are in the opposite (antiparallel) orientation, as shown in FIG. 10. Consequently, such a junction can be switched between two states of electrical resistance, one of low resistance and one of high resistance. Based on the resistance, the position of the magnet 1200 can be determined.

The above explanation is based on the assumption that the MR sensor is a TMR sensor. The present disclosure may be applicable to other sensors using a magnetoresistive effect such as GMR and AMR sensors.

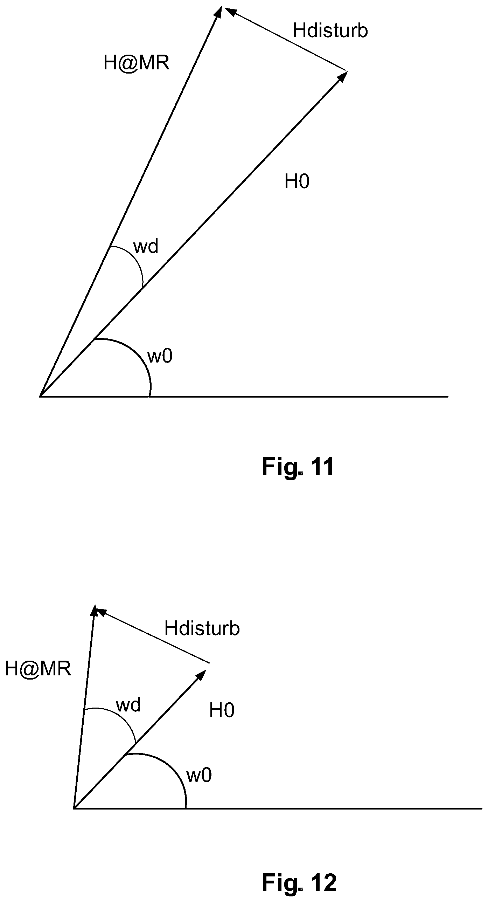

In particular, such sensors may be used for encoders. For example, in an encoder an external magnetic field H0 is provided, e.g. by the permanent magnet 1200 of Figs. 9 and 10. This external magnetic field H0 can be disturbed by a disturbance field Hdisturb, as shown in Figs. 11 and 12. The resulting magnetic field at the sensor is indicated in Figs. 11 and 12 as H@MR. In a case not shown, with no disturbance field, the external magnetic field H0 and the resulting magnetic field are equal. As shown in Figs. 11 and 12, increasing the strength of the external magnetic field H0 reduces the influence of the disturbance field Hdisturb on the resulting magnetic field H@MR. In other words, a high external magnetic field H0 reduces the influence of disturbing fields for a position sensor.

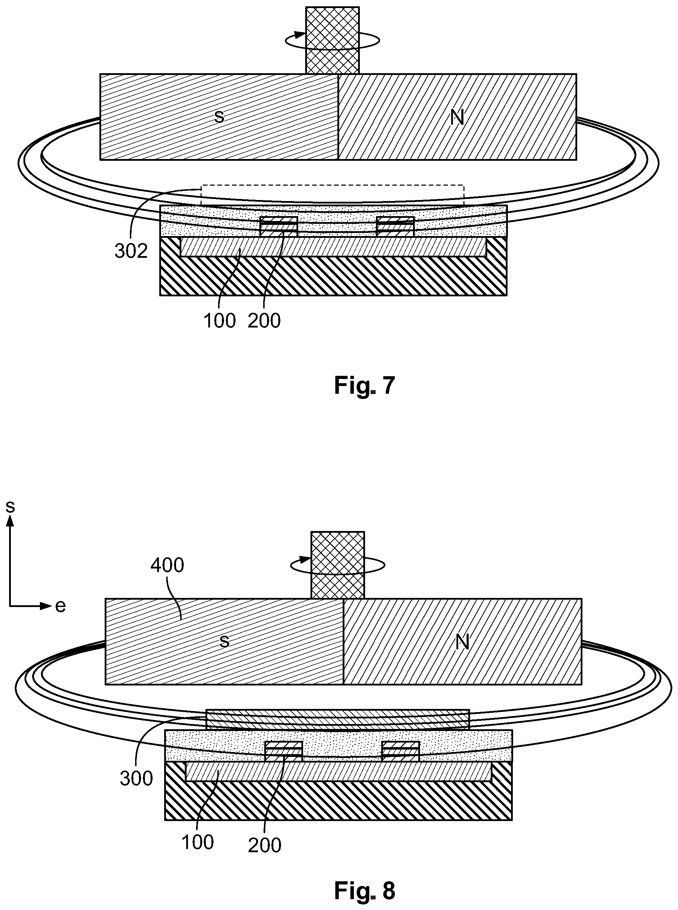

As discussed above with respect to the general aspect, the present disclosure relates to a monolithic die comprising a circuitry 100 and a magnetoresistance (MR) sensor 200 as shown in Figs. 7 and 8.

However, magnetoresistive (MR) sensors, including GMR and TMR types, have limitations when exposed to high magnetic fields. One problem is saturation, where the sensor's resistance change becomes non-linear or stops responding effectively above a certain field strength, leading to measurement inaccuracies. In addition, prolonged exposure to high magnetic fields can cause drifts, e.g. due to magnetic domain reorientation or hysteresis effects, which reduce the long-term stability and repeatability of the sensor. In particular, GMR and TMR sensors may experience permanent magnetization shifts or degradation in their tunneling layers, affecting sensitivity. Integrated TMR sensors can have an operating magnetic field range of up to 160 mT.

As discussed above, the monolithic die of the present disclosure further comprises an attenuating layer 30 comprising a magnetic flux concentrator (MFC) 300 for attenuating the external magnetic field through the MR sensor. This is shown in FIG. 8. The magnetic field is guided through the MFC 300 and the magnetic field strength at the MR sensor 200 is reduced compared to the solution in Fig. 7 where no MFC is provided, which is indicated by the box 302.

For example, the monolithic die comprising the MFC 300 facilitates to reduce the effects of external magnetic fields, to increase sensitivity, and to prevent degradation of the sensor due to effects such as saturation or drift.

As discussed above, the present disclosure is not limited to encoders, but may be applicable to other sensors that sense changes in a magnetic field, such as current sensors. Further, the following description, with reference to the figures, discusses a sensing layer having a plurality of MR sensors. However, a single MR sensor may also be possible. Further, the following description focuses in particular on a TMR sensor, but other MR sensors such as a GMR or AMR may also be possible.

A first aspect of the present disclosure relates to an integrated circuit (IC) having a layered structure.

As used herein, an **integrated circuit** (IC), also known as a microchip or simply a chip, is a set of electronic circuits comprising various electronic components (such as transistors, resistors, and capacitors) and their interconnections. These components are for example etched onto a small, flat piece ("chip") of semiconductor material, usually silicon.

As used herein, a **layered structure** refers to a material or system composed of multiple distinct layers, each with unique properties, functions, or compositions. These layers can be stacked in a controlled manner to achieve specific mechanical, electrical, optical, and/or magnetic properties.

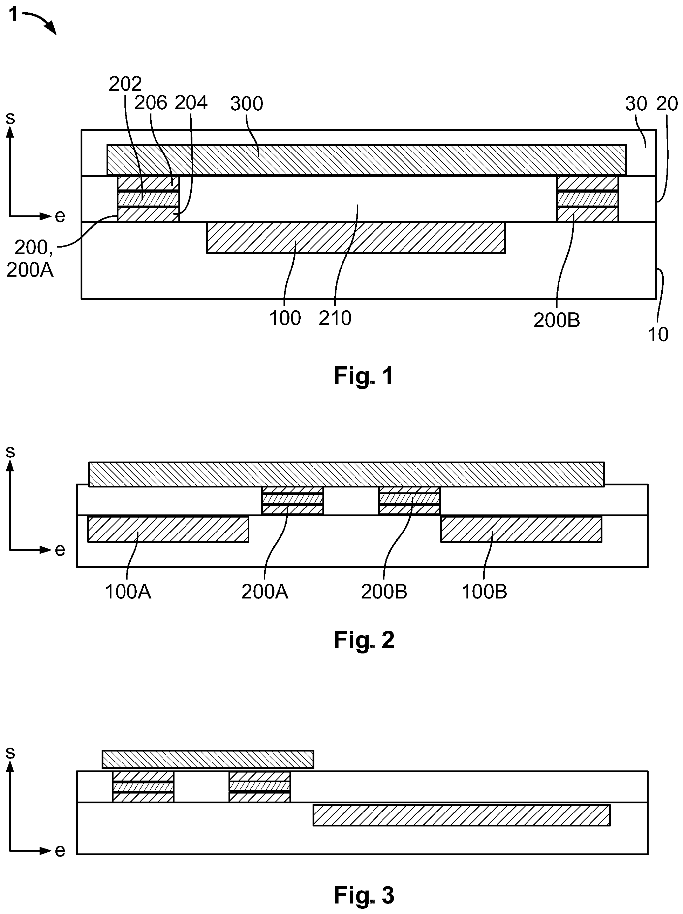

According to the first aspect, shown in Fig. 1, the IC 1 comprises a processing layer 10 comprising a circuitry 100 for communicating with a magnetoresistance (MR) sensor 200. In particular, the processing layer 10 is for example a layer using complementary metal-oxide-semiconductor (CMOS) technology. In particular, it is involved in the manipulation, transformation and control of electrical and magnetic signals. The circuitry 100 may comprise a plurality of interconnected electronic components that work together to perform a specific function. In particular, the circuitry 100 can be configured for measuring a resistance across the MR sensor 200.

The IC 1 further comprises a sensing layer 20 comprising the MR sensor 200 for detecting an external magnetic field. The MR sensor 200 is for example a layered structure, which is structured for example using photolithographic processes.

The integration of an MR sensor 200 with a processing layer 10 in a monolithic die can follow a sequential approach, wherein the MR sensor 200 is deposited after the processing layer is fabricated. For example, the MR sensor 200, e.g., comprising GMR or TMR materials, is sputter deposited onto the wafer comprising the processing layer 10.

During processing, it may be contemplated that temperature is controlled, e.g., ensuring low thermal processing (< 400°C) to avoid circuit degradation. For example, structuring processes, such as lithography and etching, may define the MR sensor 200, and surface metal interconnects or vertical interconnects (VIAS) may provide electrical connections to the processing layer.

With respect to Figs. 1 to 6, variants are shown in which the sensing layer 20 is separated from the processing layer 10 in a die stacking direction s. In addition, as shown for example in Figure 1, the sensing layer 20 is separated from the processing layer 10 in a die extension direction e perpendicular to the die stacking direction. Alternatively, although not shown in the figures, it is sufficient for the sensing layer to be separated from the processing layer 10 in at least one of the die stacking direction and the die extension direction e.

Further, the IC 1 comprises an attenuating layer 30 comprising or consisting of a magnetic flux concentrator (MFC) 300 for attenuating the external magnetic field through the MR sensor 200.

With reference to Figs. 1 to 6, the attenuating layer 30 is separated from the processing layer 10 and the sensing layer 20 in the die stacking direction s.

The MFC 300 affects the external magnetic field by redirecting it. The MFC 300 makes it possible to protect the MR sensor 200 from too strong magnetic fields by redirecting a part of the magnetic flux into a certain area, here the MFC 300. The MFC 300 is typically made of high magnetic permeability material, which conducts magnetic fields more efficiently than low permeability materials. Thus, according to the first aspect, the MFC 300 facilitates, for example, improving signal detection by attenuating the magnetic field H@MR to a field strength at which the MR sensor 200 does not experience saturation or drift. This, in turn, facilitates to increase the strength of the externally applied field H0, thus reducing the influence of the external fields Hdisturb, as discussed in Figs. 11 and 12.

For example, the MFC has a thickness in the die stacking direction s of equal to or greater than 0.001 mm, preferably equal to or greater than 0.01 mm. Additionally or alternatively, the MFC has a thickness in the die stacking direction s of equal to or less than 0.0001 mm, preferably equal to or less than 0.05 mm. This facilitates a structure of the MFC that attenuates the magnetic field at the MR sensor to the range of operation of e.g. the limited range of operation of the TMR sensor, even when operating close to a permanent magnet.

The MFC has a width and/or length in the die extension direction e of equal to or greater than 0.001 mm, preferably equal to or greater than 0.05 mm. Additionally or alternatively, the MFC has width and/or length in the die extension direction e of equal to or less than 2 mm, preferably equal to or less than 1 mm. is facilitates a structure of the MFC that attenuates the magnetic field at the MR sensor to the operating range of, for example, the limited operating range of the TMR sensor, even when operating in proximity to a permanent magnet.

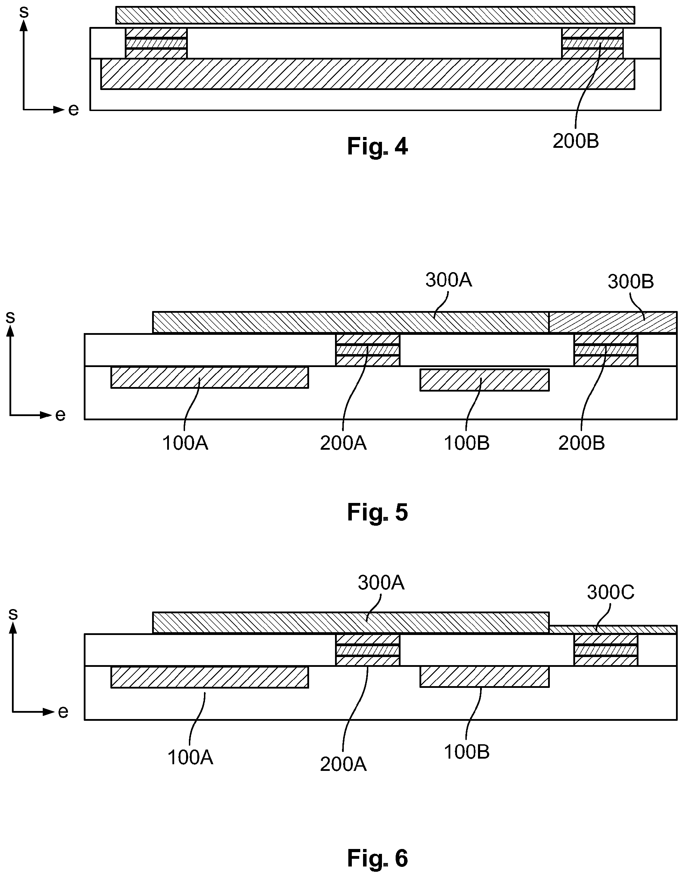

According to one option, the attenuating layer 30 may comprise a plurality of a-MFC sections, wherein a thickness of a first MFC section in the die stacking direction s is different compared to a thickness of a second MFC section the die stacking direction s. This solution is illustrated in Fig. 6, for example. By varying the thickness, the attenuation in for different section arranged along the extension direction e can be adjusted. For example, if the sensing layer 20 comprises a plurality of MR sensors arranged along the die extension direction, the attenuation can be adjusted for each sensor individually. Similarly, the width and/or length of the MFC sections can be adjusted.

The MFC 300 comprised in the attenuating layer 30 may comprise at least one of the materials ferrite, permalloy, NiFeMo, supermalloy, Iron alloy, Cobalt alloy, and Manganese alloy. Such materials facilitate to attenuate the magnetic field to which the MR sensor 200 is exposed to. In particular, the MFC 300 may comprise soft magnetic materials, in particular such soft magnetic materials that can be applied by printing, especially inkjet or screen printing.

As discussed above with respect to the general aspect, a monolithic die comprises the processing layer 10, the sensing layer 20, and the attenuating layer 30. In particular, the attenuating layer 30 may be deposited on the wafer after completion of the processing layer 10, e.g., completion of CMOS layer processes, and the sensing layer 20.

Such a monolithic die facilitates low-cost production and facilitates MR integrated sensors to extend the operating magnetic field such as 160mT for TMR sensors and reduce the MR sensing element parameters drift to zero. In particular, it makes it possible to build ICs on a single chip that can be used for rotary sensors, for example.

According to a second aspect, the sensing layer 20 of the IC die of aspect 1 can be disposed between the processing layer 10 and the attenuating layer 30. In other words, all three layers are separated in the die stacking direction s. This solution is shown, for example, in Figs. 1 to 6. This solution facilitates economical manufacturing.

According to a third aspect, the MFC 300 of the IC of any one of aspects 1 to 2 comprises a material having a higher magnetic permeability than the sensing layer 20. The sensing layer 20 may comprise a filler 210 in addition to the MR sensor 200. The material of the filler 210 may be, for example, SiO₂, Si₃N₄, or polymer coatings. Such materials have a permeability very close to that of free space because these materials are nonmagnetic materials, i.e., have a permeability close to µ0 = 1.257 ×10-6 H/m. The attenuating layer comprising a material such as permalloy has a permeability that about 100,000 times µ0. The filler 210 may be an encapsulation that additionally facilitates protecting the MR sensor 200 from at least one of contamination, oxidation, and mechanical damage. As indicated by the schematics shown in Figs. 1 to 6, the sensing layer 20 may primarily comprise the filler 210, and thus the permeability of the sensing layer 20 may be approximately the permeability of the material of the filler 210. Selecting a higher permeability for the sensing layer 20 compared to the attenuation layer 30 facilitates attenuation of the magnetic field to which the MR sensor 200 is exposed.

For example, the permeability of the MFC is equal to or greater than 100 times the permeability of the sensing layer 20, preferably equal to or greater than 1 000 times. Additionally or alternatively, the permeability of the MFC is equal to or less than 100 000 times the permeability of the sensing layer 20, preferably equal to or greater than 1 000 000 times.

According to an option of the second aspect, the attenuating layer 30 may comprise a plurality of MFC sections, wherein the magnetic permeability of a first MFC section is different from the magnetic permeability of a second MFC section. This solution is illustrated in Fig. 5.

According to a fourth aspect, the MR sensor of the IC according to any one of aspects 1 to 3 comprises a tunnel magnetic resonance (TMR) sensor. In particular, the TMR sensor, for example shown in Fig. 1, comprises an insulating layer 202 disposed between two ferromagnetic layers 204, 206 comprising ferromagnetic material. The direction of the two magnetizations of the ferromagnetic layers can be individually rotated by an external magnetic field. For example, one ferromagnetic layer 206 faces the attenuating layer 30. In other words, the die stacking direction s of the TMR is the die stacking direction s of the processing layer 10 and the attenuating layer 30.

According to a fifth aspect, the circuitry 100 of the IC according to any one of aspects 1 to 4 comprises a processing unit configured for processing signals received from the MR sensor 200. The processing unit may communicate with the MR sensor for receiving measurement values. Additionally or alternatively, the circuitry 100 may comprise an interface unit for outputting signals received from the MR sensor 200 or the processing unit to an external unit.

According to a sixth aspect, the sensing layer 200 of the IC according to any one of aspects 1 to 5 comprises a plurality of MR sensors 200A and 200B. For example, the plurality of sensors may interconnected, for example forming a bridge circuit. Even more MR sensors may be considered. For example, a plurality of four MR sensors may be interconnected to form a at least a part of a Wheatstone bridge.

In more detail, according to an opinion of the fifth aspect, the sensing layer 200 can comprise a plurality of integrated MR sensors. According to a first variant shown in Fig. 1, each integrated MR sensor comprises a MR sensor 200A, 200B and circuitry 100 communicating with the plurality of MR sensors 200A, 200B. According to a second variant shown in Fig. 2, each integrated MR sensor comprises a MR sensor 200A, 200B and a circuitry 100A, 100B communicating with the one MR sensor 200A, 200B.

Additionally or alternatively, according to a further opinion of the fifth aspect, the sensing layer comprises a plurality of attenuated MR sensors. According to a first variant shown in Fig. 1, each attenuated MR sensor comprising a plurality of MR sensors 200A, 200B and a MCR 300. According to a second variant shown in Fig. 5, each attenuated MR sensor comprising one MR sensor 200A, 200B and a MCR 300A, 300B.

According to a seventh aspect, the processing layer 100, the sensing layer 200, and the attenuating layer 300 of the IC according to any one of aspects 1 to 6 are stacked in the die stacking direction s, as for example shown in Figs. 1 to 6, and extend in a die extension direction e perpendicular to the die stacking direction s.

According to an option, as for example shown in Fig. 1, the insulating layer 202 of the MR sensor 200, as for example discussed in aspect 4, extends in the die extension direction 2.

According to an eighth aspect, the at least one MR sensor 200 overlaps the MFC 300 of the IC according to aspect 7 in the die stacking direction s, as for example shown in Figs. 1 to 6. This facilitates efficient attenuation of the magnetic field strength at the MR sensor.

According to an option of aspect 8, the at least one MR sensor 200 does not overlap the circuitry 300 in the die stacking direction s. This solution is for example shown in Figs. 1 to 3, 5, and 6. This facilitates to simplify the manufacturing of the sensor layer 20 on top of the processing layer 10.

According to a further option of aspect 8, the at least one MFC 300 does not overlap the circuitry 100 in the die stacking direction s. This solution is for example shown in Fig. 3. This facilitates to simplify the manufacturing of an attenuated sensor layer on top of the processing layer 10.

According to an ninth aspect, the circuitry 100 overlaps the MR sensor 200 of the IC according to any one of aspects 7 to 8 in the die stacking direction s. This solution is for example shown in Fig. 4. This solution facilitates a compact arrangement.

According to a tenth aspect, the MFC 300 of the IC according to any one of aspects 7 to 9 is larger than the MR sensor 200 in the die extension direction e. This solution is for example shown in Figs. 1 to 6. This facilitates efficient attenuation of the magnetic field strength at the MR sensor.

Additionally or alternatively, the circuitry 100 of the IC according to any one of aspects 7 to 9 is larger than the MR sensor 200 in the die extension direction e. This simplifies the fabrication of the circuitry.

According to an eleventh aspect, at least one MR sensor 200 of the IC according to any one of aspects 6 to 9, wherein is disposed in a central region in the die extension direction e. This solution is for example shown in Fig. 2. A central region is in a range of equal to or greater than 1/3 and equal to or less than 2/3 of the total length of the sensor layer in the extension direction. This facilitates efficient attenuation of the magnetic field strength at the MR sensor.

Additionally or alternatively, at least one MR sensor is disposed at an edge in the die extension direction e. An edge is in a range of less than 1/3, preferably less than ¼, or greater than 2/3 preferably greater than ¾, of the total length of the sensor layer in the extension direction.

The present disclosure additionally relates to a fabrication method for fabricating a monolithic die, the fabrication method comprising:
Forming, for example by processes including structuring, e.g. by lithography, and/or etching, a processing layer comprising a circuitry for communicating with a magnetoresistance, MR, sensor;
Forming, for example by processes including structuring, e.g. by lithography, and/or etching, a sensing layer comprising the MR sensor for detecting an external magnetic field; and
Forming, for example sputtering, an attenuating layer comprising a magnetic flux concentrator, MFC, for attenuating the external magnetic field through the MR sensor.

With reference to the fabrication method is referred to the above description of aspects 1 to 10.

The present disclosure additionally relates to a magnetic sensor comprising an IC according to any of the aspects 1 to 11 or a IC fabricated according the above fabrication method. The sensor is at least one of a rotary, speed, position, and current sensor.

The present disclosure additionally relates to an encoder comprising a magnetic sensor described above and a permanent magnet for producing the external magnetic field detected by the MR sensor of the IC. This solution is for example shown in Fig. 8. As for example shown in Fig. 8, the encoder is a rotary encoder.

Variants of the present disclosure will now be described in detail with reference to Figs. 1 through 6 and 8.

According to a first variant shown in Fig. 1, the integrated circuit (IC) 1 has a layered structure with a processing layer 10, a sensing layer 20, and an attenuating layer 30. The processing layer 10, the sensing layer 20, and the attenuating layer 30 are included in the layered structure. The layers according to the example are be stacked in a die stacking direction s and extend in a die extension direction perpendicular to the die stacking direction e. The sensing layer 20 according to the example are arranged between the processing layer 10 and the attenuating layer 30. The IC is a monolithic die comprising the processing layer 10, the sensing layer 20, and the attenuation layer 30.

The processing layer 10 comprises a circuitry 100 for communicating with a plurality of MR sensors 200A and 200B. The circuitry 100 is for example realized on a structure such as a silicon wafer. The circuitry 100 comprises one or a plurality of functional units. For example, the circuitry 100 may comprise a processing unit configured for processing signals received from the MR sensors 200A, 200B. Additionally or alternatively, the circuitry 100 comprises an interface unit for outputting signals received from the MR sensor or the processing unit.

The sensing layer 20 comprises a plurality of for example two TMR sensors 200 for detecting an external magnetic field. Additionally, the sensing layer 20 according to the example are comprises a filler 210 encapsulating the TMR sensors 200. The TMR sensor comprises an insulating layer 202 arranged between two ferromagnetic layers 204, 206 comprising ferromagnetic material. The insulating layer 202 of the TMR sensor according to the example extends in the die extension direction e. Each of the TMR sensors according to the example are is disposed at an edge in the die extension direction e. In particular, the sensors are arranged at opposing edges of the IC 1.

The attenuating layer 30 comprises a magnetic flux concentrator (MFC) 300 for attenuating the external magnetic field through the MR sensor. The attenuating layer 30 may comprise further elements, e.g. a protective layer such as a coating, or may consist of the MFC. The MFC 300 may comprise a material having a higher magnetic permeability than the sensing layer 20. For example, the sensing layer 20 may comprise mainly a filler 210 with a low permeability.

In the example in Fig. 1, the MFC 300 overlaps the plurality of TMR sensors 200 in the die stacking direction s. In particular, the MFC 300 is larger than the TMR sensors 200 in the die extension direction e. In other words, the sensing layer 20 comprises a plurality of attenuated MR sensors, each attenuated MR sensor comprising one TMR sensor 200 and the MCR 300. The TMR sensors 200 and the circuitry 100 do not overlap in the die stacking direction s.

According to a second variant, shown in Fig. 2, a variant is shown that is similar to the first variant. Different is that the processing layer 10 comprises a plurality of circuitries 100A, 100B. Further, the circuitries 100A, 100B are arranged at opposing edges of the IC. A further difference is that the TMR sensors 200A, 200B are arranged at a central region. In other words, the variant of Fig. 2 shows that, for example depending on the application, the present disclosure facilitates to arrange the MR sensors at a central region or at an edge region of the IC. Additionally, the circuitry 100 may be arranged at any position, for example at the edge or at a central region of the IC.

According to a third variant, shown in Fig. 3, a variant is shown that is similar to the first variant. Different is that the IC is divided into a plurality of parts in the extension direction e. In other words, the parts are abutting in the extension direction. A first part of the IC comprises attenuated TMR sensors. A second part of the IC comprises the circuitry. In other words, the variant of Fig. 3 shows that, for example depending on the application, the present disclosure facilitates not to cover the whole IC with the attenuating layer 30.

According to a fourth variant, shown in Fig. 4, a variant is shown that is similar to the first variant. Different is that the TMR sensors 200 overlaps the circuitry 100 in the die stacking direction s. The circuitry is larger than the MR sensor in the die extension direction e. This variant shows that the MR sensor may overlap with the circuitry in the die stacking direction s.

According to a fifth variant, shown in Fig. 5, a variant is shown that is similar to the first variant. Different is that one TMR sensor 200A is arranged in a central region of the IC and a second TMR sensor 200 B is arranged at an edge of the IC. Further, the circuitry is divided in two circuitry parts 100A and 200A. Further, the attenuating layer comprises a plurality of MFC sections, wherein the magnetic permeability of a first MFC section 300A is different compared to the magnetic permeability of a second MFC section 300B. In other words, the concentration capability of the attenuating layer 30 may vary in the die extension direction e by varying the permeability.

According to a sixth variant, shown in Fig. 6, a variant is shown that is similar to the fifth variant. Different is that the attenuating layer comprises a plurality of MFC sections, wherein the thickness of a first MFC section 300A is different compared to the thickness of a second MFC section 300C. Variation of the thickness is an alternative to varying the permeability of the material for adjusting the concentration capability of the attenuating layer 30.

Each of the ICs discussed above may be implemented in a rotary encoder as shown in Fig. 8. In particular, poles of a rod-like permanent magnet 400 may be arranged along the die extension direction e. Thus, an approximately parallel magnetic field is generated at the sensor 200, wherein the magnetic field is parallel to the rod-like permanent magnet 400. Here, the permanent magnet 400 rotates about a die stacking direction s. As explained with reference to Figs. 9 and 10, depending on the rotational position, the resistance across the MR changes, and thus the rotational position of the permanent magnet 400 can be determined.

A similar approach can be used for a linear position sensor. In addition, a current through a conductor can be determined from the magnetic field around a wire.

Although not shown with reference to the figures, the present application discusses a fabrication method for a monolithic die, the fabrication method comprising forming a processing layer comprising a circuit for communicating with a magnetoresistance sensor; forming a sensing layer comprising the MR sensor for detecting an external magnetic field; and forming an attenuating layer comprising a magnetic flux concentrator for attenuating the external magnetic field through the MR sensor.

### REFERENCE NUMERALS

| **Reference Numeral** | **Description** |
|---|---|
| 1 | Integrated circuit |
| 10 | processing layer |
| 20 | sensing layer |
| 30 | attenuating layer |
| 100, 100A, 100B | circuitry |
| 200, 200A, 200B | MR sensor |
| 202, 1120 | insulating layer |
| 204, 206, 1112, 1114 | ferromagnetic layers |
| 210 | Filler |
| 300, 300A, 300B, 300C | MCF |
| 400, 1200 | Permanent magnet |
| 1000 | encoder |

## Claims

1. An integrated circuit, IC, (1) having a layered structure with:
a processing layer (10) comprising a circuitry (100) for communicating with a magnetoresistance, MR, sensor (200);
a sensing layer (20) comprising the MR sensor (200) for detecting an external magnetic field (H0); and
an attenuating layer (30) comprising a magnetic flux concentrator, MFC, (300) for attenuating the external magnetic field (H0) through the MR sensor (200);
wherein a monolithic die comprises the processing layer (10), the sensing layer (20), and the attenuation layer (30).

2. The IC (1) according to claim 1, wherein the sensing layer (20) is arranged between the processing layer (10) and the attenuating layer (30).

3. The IC (1) according to any one of claims 1 to 2, wherein the MFC (300) comprises a material having a higher magnetic permeability than the sensing layer,
optionally wherein the attenuating layer (30) comprises a plurality of MFC sections (300A, 300B), the magnetic permeability of a first MFC section (300A) being different from the magnetic permeability of a second MFC section (300B).

4. The IC (1) according to any one of claims 1 to 3, wherein the MR sensor (200) comprises a tunnel magnetoresistance sensor, TMR,
optionally wherein the TMR sensor comprises an insulating layer (202) arranged between two ferromagnetic layers (204, 206) comprising ferromagnetic material.

5. The IC (1) according to any one of claims 1 to 4, wherein the circuitry (100) comprises at least one of a processing unit configured for processing signals received from the MR sensor (200) and an interface unit for outputting signals received from the MR sensor (200) or the processing unit.

6. The IC (1) according to any one of claims 1 to 5, wherein the sensing layer (20) comprises a plurality of MR sensors (200A, 200B);
optionally wherein the sensing layer (20) comprises a plurality of integrated MR sensors, each integrated MR sensor comprising at least one MR sensor (200A, 200B) and a circuitry (100A, 100B) communicating with the at least one MR sensor (200A, 200B);
optionally wherein the sensing layer (20) comprises a plurality of attenuated MR sensors, each attenuated MR sensor comprising at least one MR sensor (200A, 200B) and a MCF (300A, 300B).

7. The IC (1) according to any one of claims 1 to 6, wherein the processing layer (10), the sensing layer (20), and the attenuating layer (30) included in the layered structure are stacked in a die stacking direction (s) and extend in a die extension direction (e) perpendicular to the die stacking direction (s),
optionally wherein an insulating layer (202) of the MR sensor (200) according to claim 4 extends in the die extension direction (e).

8. The IC (1) according to claim 7, wherein the at least one MR sensor (200) and the MFC (300) are overlapping in the die stacking direction (s);
optionally wherein the at least one MR sensor (200) and the circuitry (100) are not overlapping in the die stacking direction (s);
optionally wherein the at least one MFC (300) and the circuitry (100) are not overlapping the die stacking direction (s).

9. The IC (1) according to any one of claims 7 to 8, wherein the circuitry (100) and the MR sensor (200) are overlapping in the die stacking direction (s); and/or
wherein the circuitry (100) and the MFC (300) are overlapping in the die stacking direction.

10. The IC (1) according to any one of claims 6 to 9, wherein the MFC (300) is larger than the MR sensor (200) in the die extension direction (e); and/or
wherein the circuitry (100) is larger than the MR sensor (200) in the die extension direction (e).

11. The IC (1) according to any one of claims 6 to 9, wherein at least one MR sensor (200) is disposed in a central region in the die extension direction (e) and/or wherein at least one MR sensor (200) is disposed at an edge in the die extension direction (e).

12. Fabrication method for manufacturing a monolithic die (1), the fabrication method comprising:
Forming an processing layer (10) comprising a circuitry (100) for communicating with a magnetoresistance, MR, sensor (200);
Forming a sensing layer (20) comprising the MR sensor (200) for detecting an external magnetic field (H0); and
Forming an attenuating layer (30) comprising a magnetic flux concentrator, MFC, (300) for attenuating the external magnetic field (H0) through the MR sensor (200).

13. Magnetic sensor comprising an IC (1) according to any of claims 1 to 11,
Optionally wherein the sensor is at least one of a rotary sensor, speed sensor, position sensor, and current sensor.

14. Encoder comprising
Magnetic sensor according to claim 13; and
a magnet (400) for producing the external magnetic field detected by the MR sensor of the IC (1).

15. The encoder according to claim 14, wherein the encoder is a rotary encoder.
